(19) Europäisches Patentamt
European Patent Office
Office européen des brevets

(11) **EP 2 386 126 B1**

(12) **EUROPEAN PATENT SPECIFICATION**

(45) Date of publication and mention
of the grant of the patent:
**12.03.2014  Bulletin 2014/11**

(21) Application number: **09789417.4**

(22) Date of filing: **09.01.2009**

(51) Int Cl.:
*H01L 35/34* *(2006.01)*      *B01J 3/06* *(2006.01)*

(86) International application number:
**PCT/US2009/030569**

(87) International publication number:
**WO 2010/080153 (15.07.2010 Gazette 2010/28)**

(54) **AFFECTING THE THERMOELECTRIC FIGURE OF MERIT (ZT) BY HIGH PRESSURE, HIGH TEMPERATURE SINTERING**

BEEINFLUSSUNG DER THERMOELEKTRISCHEN KENNZAHL (ZT) DURCH HOCHDRUCK-HOCHTEMPERATURSINTERUNG

RÉGLAGE DU FACTEUR DE MÉRITE (ZT) THERMOÉLECTRIQUE PAR FRITTAGE À HAUTE TEMPÉRATURE ET À HAUTE PRESSION

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**16.11.2011  Bulletin 2011/46**

(73) Proprietor: **Diamond Innovations, Inc.
Worthington, OH 43085 (US)**

(72) Inventors:
• **MALIK, Abds-sami
Westerville
OH 43601 (US)**
• **DONG, Yongkwan
Kyo-dong Sokcho-city
Kangwon-do 217-060 (KR)**
• **DISALVO, Francis, J.
Ithaca
NY 14850 (US)**

(74) Representative: **Hammarsjö, Joakim et al
Sandvik Intellectual Property AB
811 81 Sandviken (SE)**

(56) References cited:
**WO-A-2008/002910     US-A1- 2006 053 969**

• **ZHU P W ET AL: "GIANT IMPROVED THERMOELECTRIC PROPERTIES IN PBTE BY HPHT AT ROOM TEMPERATURE" CHEMICAL PHYSICS LETTERS, NORTH-HOLLAND, AMSTERDAM, vol. 359, 1 January 2002 (2002-01-01), pages 89-94, XP002476728 ISSN: 0009-2614**
• **ZHU P W ET AL: "A new method of synthesis for thermoelectric materials: HPHT" SOLID STATE COMMUNICATIONS, OXFORD, vol. 123, 1 January 2002 (2002-01-01), pages 43-47, XP002476729 ISSN: 0038-1098**
• **SU T ET AL: "Electrical transport and thermoelectric properties of PbTe doped with Sb2Te3 prepared by high-pressure and high-temperature" JOURNAL OF ALLOYS AND COMPOUNDS, ELSEVIER SEQUOIA, LAUSANNE, CH, vol. 422, no. 1-2, 28 September 2006 (2006-09-28), pages 328-331, XP025140525 ISSN: 0925-8388 [retrieved on 2006-09-28]**
• **SU T ET AL: "Thermoelectric properties of nonstoichiometric PbTe prepared by HPHT" JOURNAL OF ALLOYS AND COMPOUNDS, ELSEVIER SEQUOIA, LAUSANNE, CH, vol. 468, no. 1-2, 22 January 2009 (2009-01-22), pages 410-413, XP025860466 ISSN: 0925-8388 [retrieved on 2008-02-21]**
• **OVSYANNIKOV SERGEY ET AL: "Pressure-tuned colossal improvement of thermoelectric efficiency of PbTe" APPLIED PHYSICS LETTERS, AIP, AMERICAN INSTITUTE OF PHYSICS, MELVILLE, NY, US, vol. 90, no. 12, 19 March 2007 (2007-03-19), pages 122103-122103, XP012093713 ISSN: 0003-6951**

- KISHIMOTO KENGO ET AL: "Preparation of sintered degenerate n-type PbTe with a small grain size and its thermoelectric properties" JOURNAL OF APPLIED PHYSICS, AMERICAN INSTITUTE OF PHYSICS. NEW YORK, US, vol. 92, no. 5, 1 September 2002 (2002-09-01), pages 2544-2549, XP012057155 ISSN: 0021-8979

- MCGUIRE M A ET AL: "Effects of high-pressure high-temperature treatment on the thermoelectric properties of PbTe", JOURNAL OF ALLOYS AND COMPOUNDS, ELSEVIER SEQUOIA, LAUSANNE, CH, vol. 460, no. 1-2, 28 July 2008 (2008-07-28), pages 8-12, XP022702283, ISSN: 0925-8388, DOI: 10.1016/J.JALLCOM. 2007.05.072 [retrieved on 2008-06-03]

**Description**

F. BACKGROUND

The Seebeck effect, or the thermoelectric effect, is the voltage difference that exists between two points of a material when a temperature gradient is established between those points. Materials, usually semiconductors or conductors, which exhibit this phenomenon, are known as thermoelectrics or thermoelectric materials. Devices made from thermoelectric materials take advantage of the Seebeck effect to convert heat into electricity. For instance, the Seebeck effect is the physical basis for a thermocouple, which is often used in temperature measurement.

Measurements of the Seebeck effect are reported as the Seebeck coefficient ($\alpha$) in units of $\mu$V/K (microvolts per Kelvin). The Seebeck coefficient can be defined as the ratio between the open circuit voltage and the temperature difference, between two points on a conductor, when a temperature difference exists between those points. The Seebeck coefficient can take either positive or negative values depending upon whether the charge carriers are holes or electrons respectively. The Seebeck coefficient is often referred to as the thermoelectric power or thermopower.

Good thermoelectric materials should possess Seebeck coefficients with large absolute values, high electrical conductivity ($\sigma$, in units of S/cm or $\Omega^{-1}$cm$^{-1}$), and low thermal conductivity ($\lambda$, in units of W/cm K). A high electrical conductivity results in minimizing Joule heating in the thermoelectric material, while a low thermal conductivity helps to maintain large temperature gradients in the material.

The efficiency of a thermoelectric material is, therefore, described by the thermoelectric figure-of-merit (Z, in units of K$^{-1}$), which is calculated by the relationship: $Z = \dfrac{\alpha^2 \sigma}{\lambda}$. A useful dimensionless figure-of-merit is defined as ZT, where T is temperature (in K), and $ZT = \dfrac{\alpha^2 \sigma T}{\lambda}$.

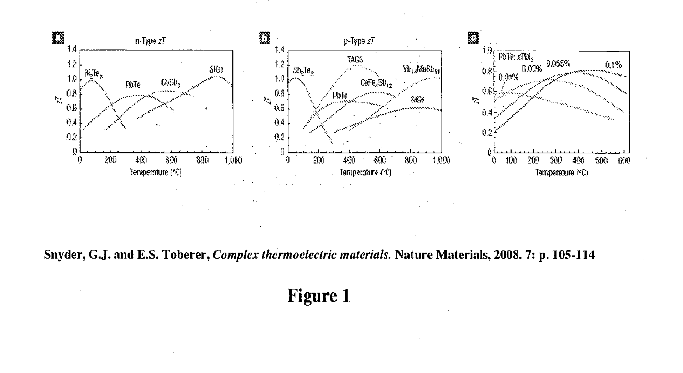

Metals and metal alloys received much interest in the early development of thermoelectric applications, but these materials have a high thermal conductivity. Furthermore, the Seebeck coefficient of most metals is on the order of 10 $\mu$V/K, or less. Depending upon the doping level semiconductors can attain Seebeck coefficients greater than 100 $\mu$V/K. Generally, semiconductors can also possess moderately high electrical conductivity and low thermal conductivity, which further increases Z, and thus the efficiency of the thermoelectric material. For instance, bismuth telluride ($Bi_2Te_3$) and lead telluride (PbTe) are two commonly used semiconductor thermoelectric materials with optimized ZT close to 1. Bismuth telluride's optimal operating temperature is around 300 K and PbTe is around 700 K. Optimized materials are complex alloy compositions, such $Sb_{1.6}Bi_{0.4}Te$, $Bi_2Te_{2.4}Se_{0.6}$, or $Pb_{0.6}Sn_{0.4}Te$, with various dopants to control thermal conductivity and carrier concentration. No commercially available materials exist with ZT substantially greater than 1. As shown in Fig. 1, no commercial materials exist with ZT of 1.5 or greater. A material possessing higher ZT is more efficient and a ZT of -4 would be required to approach the thermodynamic efficiencies obtained by conventional internal combustion engines.

As mentioned above, optimizing the ZT of a material generally involves synthetic methods by which the stoichiometry of the starting material is altered by doping or alloying with aleovlent elements. Dopants are generally intended to increase the electrical conductivity of the material, while alloying is intended to reduce the thermal conductivity. Often, this leads to a material with an entirely different composition from the parent compound. However, in many materials dopants are not electrically active, due to the presence of compensating defects that are induced or modified by doping. Consequently, there is no easy way to predict the Seebeck coefficient of the resulting material composition, which can be diminished due to doping and alloying.

The publication by P. W ZHU ET AL: "Giant improved thermoelectric properties in PbTe by HPHT at room temperature", CHEMICAL PHYSICS LETTERS, vol. 359, 2002, pages 89-94, XP002476728, as well as P.W. ZHU ET AL: "A new method of synthesis for thermoelectric materials: HPHT", SOLID STATE COMMUNICATIONS, vol. 123, 2002, pages 43-47, XP002476729 and SU ET AL: "Electrical transport and thermoelectric properties of PbTe doped with Sb2Te3 prepared by high-pressure and high-temperature", JOURNAL OF ALLOYS AND COMPOUNDS, ELSEVIER SEQUOIA, LAUSANNE, CH, [Online] vol. 422, no. 1-2, 26 January 2006 (2006-01-26), pages 328-331, XP005613231, ISSN: 0925-8388 disclose forming PbTe from high purity elemental powders under high pressure and high temperature conditions.

The publication SHCHENNIKOV V V ET AL: "Thermopower of lead chalcogenides at high pressures", PHYSICS OF THE SOLID STATE, NAUKA/INTERPERIODICA, MO, vol. 44, no. 10, 1 October 2002 (2002-10-01), pages 1845-1849, XP019310503, ISSN: 1090-6460 discloses a method of influencing the thermopower of PbX crystals under high hydrostatic pressures.

POLVANI D A ET AL: "Large improvement in thermoelectric properties in pressure-tuned p-type Sb1.5Bi0.5Te3", Database accession no. 7532638 ; & Chemistry of Materials American Chem. Soc. USA, vol. 13, no. 6 , pages 2068-2071, ISSN: 0897-4756, DOI: DOI: 10. 1021 /CM000888Q discloses pressure tuning of p-doped antimony bismuth telluride under nonhydrostatic compression conditions.

MENG J F ET AL: "Multifold enhancement of the thermoelectric figure of merit in p-type BaBiTe3 by pressure tuning", JOURNAL OF APPLIED PHYSICS, AMERICAN INSTITUTE OF PHYSICS. NEW YORK, US, vol. 90, no. 6, 15 September 2001 (2001-09-15), pages 2836-2839, XP012054140, ISSN: 0021-8979, DOI: DOI: 10.1063/1.1394905 discloses increasing thermopower of p-type BaBiTe3 under pressures of up to 1.2GPa.

WO 2008/002910 A (DIAMOND INNOVATIONS INC [US]; MALIK ABDS-SAMI [US]) 3 January 2008 (2008-01-03) discloses a method of increasing the Seebeck coefficient of a semiconductor by HPHT sintering.

MCGUIRE M A ET AL: "Effects of high-pressure high-temperature treatment on the thermoelectric properties of PbTe", JOURNAL OF ALLOYS AND COMPOUNDS, ELSEVIER SEQUOIA, LAUSANNE, CH, vol. 460, no. 1-2, 28 July 2008 (2008-07-28), pages 8-12, XP022702283, ISSN: 0925-8388, DOI: 10.1016/J.JALLCOM.2007.05.072 discloses HPHT treatment of PbTe presents measurements of the figure of merit ZT.

Accordingly, there remains a need for materials with high ZT (greater than unity). In addition, there remains a need for a method to increase the ZT of a material that does not depend solely on doping or alloying, but perhaps, for example, by controlling or modifying intrinsic defects. Embodiments herein address these and other needs.

## G. SUMMARY

A method of increasing the ZT of a semiconductor thermoelectric includes exposing it to elevated pressure and elevated temperature for a time sufficient to sinter the material and increase the ZT of the semiconductor thermoelectric, when measured at the pressure of use (i.e. ambient pressure), and recovering the semiconductor, according to claim 1.

In embodiments, the pressure ranges from about 4 GPa to about 8 GPa, and preferably about 4 GPa.

In exemplary embodiments, the temperature ranges from about 900 °C to about the melting point of the semiconductor at the process pressures.

In exemplary embodiments, the semiconductor may be selenides, antimonides, tellurides, sulfides, germanium compounds, and alloy mixtures thereof and dopants may be added and may include, for example, Br, Cl, I, Ga, In, Na, K, Ag, or other intentional impurities to change the electrical or thermal conductivity of the base material. In still other embodiments, the semiconductor may be lead selenide, lead sulfide, lead telluride, tin sulfide, tin telluride, and alloy mixtures thereof. In an exemplary embodiment, the semiconductor is lead telluride.

In embodiments, a time sufficient to affect the ZT of a semiconductor may range from about 30 seconds to about 24 hours. In yet another embodiment, the time may be from about 5 minutes to about 30 minutes. In still another embodiment, the time may be about 5 minutes to about 15 minutes.

In an exemplary embodiment, the semiconductor may include a semiconductor starting powder, where the semiconductor starting powder has an average grain size less than 1 $\mu$m to about 4000 $\mu$m. In other embodiments, the starting semiconductor may be a polycrystalline mass or one or more discrete single crystals.

Another exemplary method may include increasing the ZT of lead telluride. The method may include exposing the lead telluride to a pressure ranging from about 3 GPa to about 8 GPa and a temperature from about 600°C to about 1300°C for a time sufficient to increase the ZT of the lead telluride when measured at the pressure and temperature of use, and recovering the lead telluride. In embodiments, a time sufficient to increase the ZT of lead telluride may be about 5 minutes to about 24 hours.

Another embodiment may include a high pressure, high temperature (HPHT)-treated high purity semiconductor material having a ZT that is higher than a semiconductor material of the same composition that is not HPHT-treated. In embodiments the semiconductor material with a ZT that is higher than a semiconductor material of the same composition that is not HPHT-treated may be selenides, antimonides, tellurides, sulfides, germanium compounds, and alloy mixtures thereof. In other embodiments, the material may be lead selenide, lead sulfide, lead telluride, tin sulfide, tin telluride, and alloy mixtures thereof. In still other embodiments the semiconductor material may be lead telluride.

## H. BRIEF DESCRIPTION OF THE DRAWINGS

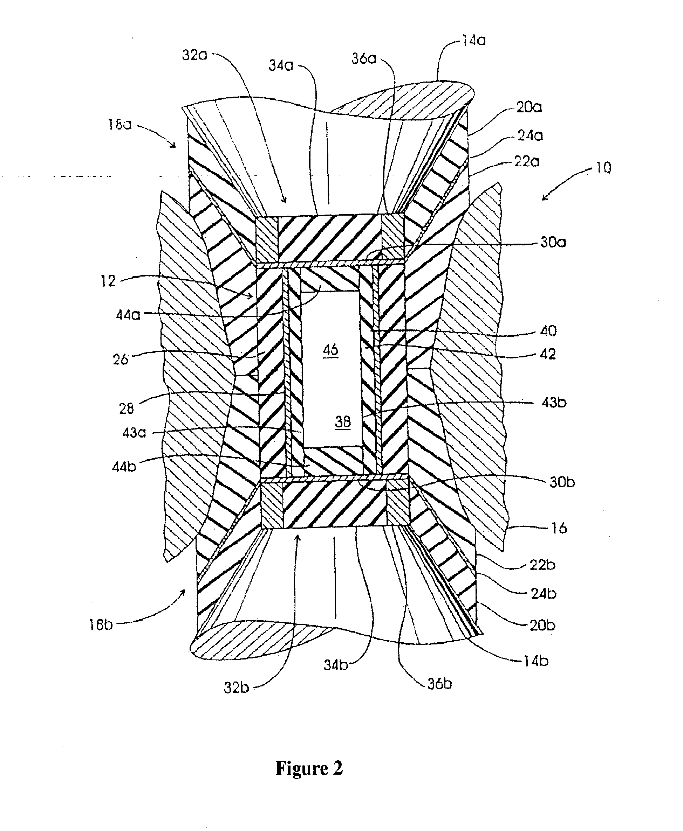

Figure 2 shows graphs the ZT of various commercially available, non-HPHT sintered thermoelectric materials.

Figures 2 and 3 show cross-sectional views of an exemplary HPHT apparatus and cell which may be utilized to increase the ZT in a semiconductor.

Figure 4 depicts ZT data plots over the temperature range 80 to 300 K for Br doped PbTe sintered using HPHT and non-HPHT methods.

Figure 5 shows the ZT for HPHT and non-HPHT sintered Ga, I, and In doped, at a level of 1.0 x 10$^{19}$ /cm$^3$, PbTe.

The HPHT sintered materials show consistently higher ZT values.

Figure 6 depicts the ZT for $Pb_{0.5}Sn_{0.5}Te_{0.5}Se_{0.5}$, doped with Br at a concentration of 1.0 x $10^{19}$ /cm$^3$, sintered at 2 different HPHT conditions: A at 3.5 GPa and 1050 °C, and B at 40 GPa and 1000 °C.

Figure 7 shows a comparison of the ZT for PbTe doped with Br at several different levels: A) 0.5, B) 1.0, D) 2.0, and E) 3.0 x $10^{19}$ /cm$^3$. These were sintered at 4.0 GPa and 1050 °C.

Figure 8 shows a comparison of the high temperature ZT of Br doped (1 x $10^{19}$ /cm$^3$) and undoped PbTe. Both samples were sintered at 4.0 GPa and 1050 °C.

## I. DETAILED DESCRIPTION

It is to be understood that the terminology used in the description is for the purpose of describing the particular versions or embodiments only.

It must also be noted that as used herein and in the appended claims, the singular forms "a," "an," and "the" include plural references unless the context clearly dictates otherwise. Unless defined otherwise, all technical and scientific terms used herein have the same meanings as commonly understood by one of ordinary skill in the art. Although any methods, materials, and devices similar or equivalent to those described herein can be used in the practice or testing of embodiments, the preferred methods, materials, and devices are now described. All publications mentioned herein are incorporated by reference. Nothing herein is to be construed as an admission that the embodiments described herein are not entitled to antedate such disclosure by virtue of prior invention.

The present embodiments are illustrated in connection with a conventional HPHT apparatus which may be of the belt- or die-type described, for example, in U.S. Pat. Nos.: 2,947,611; 2,941,241; 2,941,248; 3,609,818; 3,767,371; 4,289,503; 4,673,414; and 4,954,139. However, it will be appreciated that the method of the present invention will find applicability in any HPHT apparatus which is capable of providing the required HP and HT conditions simultaneously. Accordingly, it is intended that such other HPHT apparatuses are within the scope of the invention herein described.

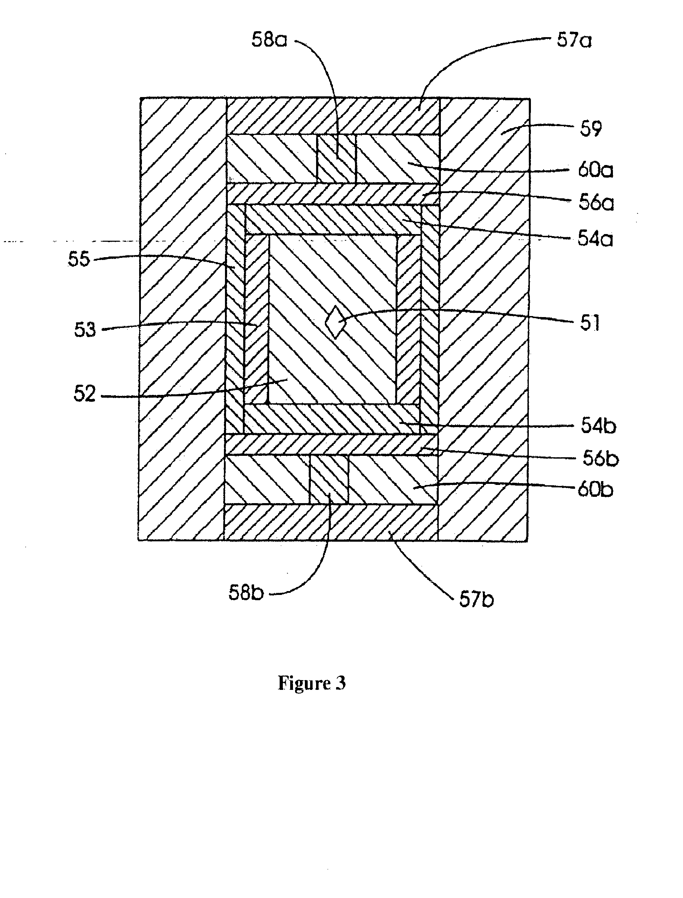

Looking to Figures 2 and 3, an illustrative HPHT apparatus useful in the practice of the present invention is shown generally at **10** to include a generally cylindrical reaction cell assembly **12** interposed between a pair of punches, **14a** and **14b,** and surrounded by a generally annular belt or die member **16.** Preferably, both punches **14** and belt member **16** are formed of a relatively hard material, such as cemented tungsten carbide. Between punches **14** and belt member **16** are a pair of insulating assemblies, **18a** and **18b,** each of which is formed of a pair of thermally and electrically insulating members, **20a-b** and **22a-b,** in some embodiments formed of pyrophyllite or the like, and having an intermediate metallic or other gasket, **24a** and **24b,** disposed there between.

As shown, reaction cell assembly **12** includes a hollow cylinder **26,** which may be formed of a material, such as salt or the like, which is converted during HPHT by phase transformation or compaction to a stronger, stiffer state or, alternatively, of a talc material or the like which is not so converted. In either case, the material of cylinder **12** is selected as being substantially free of volume discontinuities or the like, under HPHT as may occur, for example, with pyrophyllite or alumina materials. Materials meeting such criteria are described in U.S. Pat. No. 3,030,662.

Positioned within salt cylinder **26** is one or more adjacent cylinders **28,** each of which is provided as a graphite electrical resistance heater tube. Electrical connection with heater tube **28** is achieved via an adjacent pair of conductive metal end discs, **30a** and **30b,** which are axially-disposed with respect to heater tube **28.** Adjacent each disc **30** is provided an end cap assembly, shown generally at **32a** and **32b,** each of which includes an insulating plug, **34a** and **34b,** surrounded by an electrically conductive ring, **36a** and **36b.**

It will be appreciated that the interior of heater **28,** along with end discs **30,** salt cylinder **26,** and end cap assemblies **32,** defines a generally-cylindrical inner chamber, shown at **38,** having defined axial and radial extents and containing a pressure-transmitting medium **46.** Pressure-transmitting medium **46** is selected as having a relatively low coefficient of internal friction to make it semi-fluid at HPHT conditions, and may be provided as or within a cylindrical salt liner **42,** which defines radial pressure-transmitting medium layers **43a** and **43b,** and is fitted with an axial pair of salt plugs, **44a** and **44b,** each of which defines an axial pressure transmitting medium layer. Preferably, pressure-transmitting medium **46,** salt liner **42** and/or plugs **44** are formed of a graphite material or of sodium chloride, but also may be formed of any chloride, iodide, or bromide of sodium, potassium, or calcium or a mixture thereof. Alternatively, pressure-transmitting medium **46** may be provided in powdered or particulate form. In either case, medium **46** defines a cavity space, which is configured to receive the semiconductor material **40** for HPHT processing with conditions sufficient to increase the ZT after recovery from HPHT processing. Such is the configuration of a representative HPHT apparatus for practicing the present invention.

In an embodiment, a method for increasing the ZT of a semiconductor includes creating a reaction cell with a semiconductor which is exposed to elevated pressure and elevated temperature for a time sufficient to increase the ZT of the semiconductor. The semiconductor with increased ZT is then recovered from the reaction cell. In an embodiment, the semiconductor 51 is shaped into a pellet before it is placed in a reaction cell.

In an embodiment for increasing the ZT of a semiconductor, the pressure ranges from about 1 GPa to about 20 GPa and the temperature ranges from about a third of the melting point temperature to about 500 °C above the melting point of the semiconductor at process pressures. In another embodiment, the pressure ranges from about 2 GPa to about 10 GPa. In yet another embodiment, the pressure ranges from about 4 GPa to about 8 GPa. In still another embodiment, the pressure is about 4 GPa.

The temperature ranges of an embodiment may be from about the temperature at which the semiconductor material sinters together at process pressures. This may be about 600° C to about 1300° C. In still another embodiment the temperature ranges from about 700°C to about 900°C. Alternatively, the temperature ranges from about 900°C to about the melting point of the semiconductor at the process pressures. In some embodiments, a preferred temperature range may be about +/- 400°C from the melting point of the semiconductor under elevated pressure.

For an embodiment of a method to increase and maintain for a period of time the ZT of a semiconductor, the semiconductor material may include lead selenide, lead sulfide, lead telluride, tin sulfide, tin telluride, lead tin telluride, thallium tin telluride, thallium germanium telluride, and alloy mixtures thereof. In still yet another embodiment the semiconductor may be lead selenide, lead sulfide, lead telluride, tin sulfide, tin telluride, and alloy mixtures thereof. In one embodiment the semiconductor may be lead telluride. It is recognized that any neat, pure, or doped semiconductor material or compound, including alloy mixtures thereof, which results in increased ZT when subjected to the HPHT treatments or HPHT sintering conditions described and claimed herein are within the scope of the instant claims. For example, dopants may be added and may include, for example, Br, Cl, I, Ga, In, Na, K, Ag, or other intentional impurities to change the electrical or thermal conductivity of the base material.

The embodiments described herein relating to PbTe consider improving the ZT of already-created PbTe, after HPHT conditions that may have created it have been removed, and not continued processing of elemental Pb and Te. The PbTe that is to be improved may be made by non-HPHT methods or HPHT methods. Exemplary methods of synthesizing PbTe for use in the embodiments described herein include mixing or combining elemental Pb and elemental Te in a processing device, and heating the mixture to about 900° C to about 1000° C under non-elevated pressure (i.e., a pressure that does not substantially vary from atmospheric pressure as compared to the HPHT conditions described above), so that the mixture melts and reacts to form PbTe. Other methods of forming PbTe are possible. The formed PbTe may then be cooled and subsequently subjected to the HPHT conditions described herein in order to improve its ZT.

In one embodiment of a method to increase the ZT of a semiconductor is to expose the semiconductor material to HPHT treatments described herein for about 30 seconds or longer up to about 24 hours. In another embodiment, the semiconductor material may be exposed to HPHT treatments for about 30 seconds to about 15 minutes. In still another embodiment, the semiconductor material may be exposed to HPHT treatments for about 5 minutes to about 30 minutes, preferably about 10 minutes.

In still yet another embodiment a method for increasing the ZT of the semiconductor lead telluride includes creating a reaction cell with the lead telluride; exposing the reaction cell to a pressure ranging from about 4 GPa to about 6 GPa and a temperature from about 700°C to about 900°C for a time sufficient to increase the ZT of the lead telluride, and recovering the lead telluride with the increased ZT.

In one embodiment, the lead telluride is exposed to the HPHT treatment conditions for about 30 seconds or longer. In another embodiment the lead telluride is exposed to the HPHT treatment conditions for about 5 minutes to about 15 minutes.

Another embodiment includes HPHT-treated high purity semiconductor material that has a ZT that is higher than a semiconductor material of the same composition that is not HPHT-treated. In an embodiment, high purity material is greater than or equal to 99.9% (w/w) pure. In another embodiment, high purity material is greater than or equal to 99.99% (w/w) pure. In still yet another embodiment, high purity material is greater than or equal to 99.999%

(w/w) pure. In embodiments, the starting semiconductor may be a powder, a polycrystalline mass, one or more discrete single crystals, or any combination thereof. The average grain size of the semiconductor starting powder ranges from about 50 $\mu$m to about 4000 $\mu$m.

In an embodiment, the high purity semiconductor may be selenides, antimonides, tellurides, sulfides, germanium compounds, and alloy mixtures thereof. In another embodiment, the high purity semiconductor material may be lead selenide, lead sulfide, lead telluride, bismuth telluride, tin sulfide, tin telluride, lead tin telluride, thallium tin telluride, thallium and germanium telluride, and alloy mixtures thereof. In another embodiment, the high purity semiconductor material may be lead selenide, lead sulfide, lead telluride, tin sulfide, tin telluride, and alloy mixtures thereof. In yet another embodiment, the high purity semiconductor material includes lead telluride.

In an exemplary embodiment, the high purity semiconductor material with increased ZT is formed by HPHT-treatment at a pressure ranging from about 1 GPa to about 20 GPa and the temperature from about 500° C to about 2500° C for about 5 minutes to about 30 minutes. In another embodiment the treatment time is about 5 minutes to about 15 minutes.

In an exemplary embodiment, the high purity semiconductor material with increased ZT is formed by HPHT-treatment at a pressure ranging from about 4 GPa to about 8 GPa and a temperature from about 600°C to about 1300°C for about 5 minutes to about 15 minutes.

EXAMPLE 1

Undoped lead telluride (PbTe) was conventionally synthesized by mixing stoichiometric amounts of the elements Pb (99.9999%, Alfa-Aesar) and Te (99.9999%, Alfa Aesar) and sealing in a silica tube under vacuum. This was then slowly heated over 18 hours to reach a temperature of 930 °C to achieve melting, mixing and reaction of the components. The temperature was held at 930 °C for 2 hours, then slowly cooled over 6 hours to reach a temperature of 850 °C, then rapidly cooled (within minutes) in air to room temperature. The solid mass was ground and sieved into a powder with particle sizes between 50-100 um. The powder was shaped into pills by cold compaction under 10 ksi pressure and either loaded into a high pressure cell for HPHT sintering or, for comparison, conventionally sintered in a vacuum sealed silica tube at temperatures of 400 °C for 12 hours. The HPHT sintering conditions were between 40 and 65 kBar pressure and 1045 °C to 1175 °C temperature, with a soak time of 10 minutes as listed in Table 1. The resulting solid was wire EDM cut into ingots for measurement of Seebeck coefficient, thermal conductivity, and electrical resistivity over a temperature range of 75 K to 300 K.

Table 1 describes the HPHT treatments applied to the PbTe pills. The data for conventionally sintered PbTe is also given for comparison. It can be seen that the ZT value for sample 2 is greatest and that of the conventionally sintered material is among the lowest. It can also be noted that obtaining higher ZT is dependent upon specific HPHT sintering conditions. This data demonstrates that there is an optimum time, temperature, and pressure leading to a maximum ZT.

**Table 1: Experimental variable and results for HPHT treated PbTe samples**

| Sample | P (GPa) | T (°C) | Time (m) | ZT @ 300K |
|--------|---------|--------|----------|-----------|
| Conv.  | N/A     | 400    | 12 h     | 1.18E-02  |
| 1      | 6.5     | 1175   | 10       | 3.03E-03  |
| 2      | 4.0     | 1045   | 10       | 1.01E-01  |
| 3      | 5.5     | 1045   | 10       | 5.08E-02  |
| 4      | 5.5     | 1175   | 10       | 1.06E-02  |

EXAMPLE 2

PbTe samples with Br dopant concentration of 1.0 x $10^{19}$ /cm$^3$ were conventionally synthesized by weighing Pb, Te, and PbBr$_2$ (99.999%, Alfa Aesar) according to the nominal stoichiometry of PbTe$_{(1-x)}$Br$_x$ using the same method described in Example 1. The tubes were slowly heated over 18 hours to reach a temperature of 950 °C, and held at this temperature for 3 hours, before rapidly cooling to room temperature.

The synthesized Br doped PbTe ingots were crushed into a powder, pressed into a pellet, and heated to 400 or 520 °C over 8 h and kept at that temperature for 12 h or 20 h before rapidly cooling, as listed in Table 2, in order to obtain conventionally sintered samples for baseline measurement of electronic properties for non-HPHT sintered materials. HPHT sintering was accomplished as described in Example 1 and listed in Table 2.

Table 2 describes the conditions and results for Br doped PbTe, both conventionally sintered and HPHT sintered. For comparison, undoped, HPHT treated, PbTe is also given (sample E). It is clear from the data that conventional sintering gives a ZT value that is very small, whereas HPHT processing yields higher ZT value.

**Table 2: Experimental variables and results for Br doped PbTe**

| Sample | P (GPa) | T (°C) | Time | Dopant (cm^-3) | ZT @ 300K |
|--------|---------|--------|------|----------------|-----------|
| A | N/A | 400 | 12 h | Br(1x10^19) | 4.41E-03 |
| B | N/A | 520 | 12 h | Br(1x10^19) | 7.12E-02 |
| C | N/A | 520 | 20 h | Br(1x10^19) | 4.44E-03 |
| D | 4.0 | 1045 | 10m | Br(1x10^19) | 2.14E-01 |
| E | 4.0 | 1045 | 10 m | N/A | 1.01E-01 |

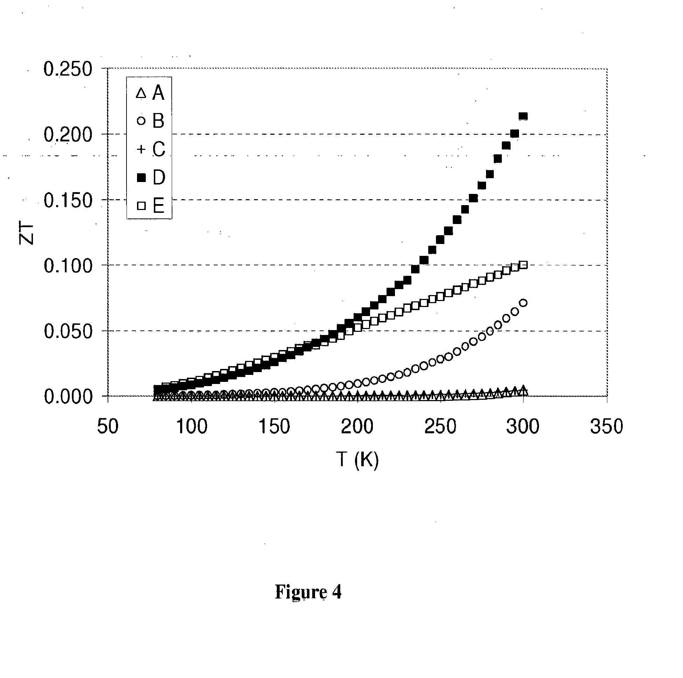

The corresponding data plots over the temperature range from 80 to 300 K for the samples listed in Table 2 are given in Figure 4. It can be seen that, almost over the entire temperature range given, the HPHT sintered, Br doped sample (D) has a superior figure of merit.

EXAMPLE 3

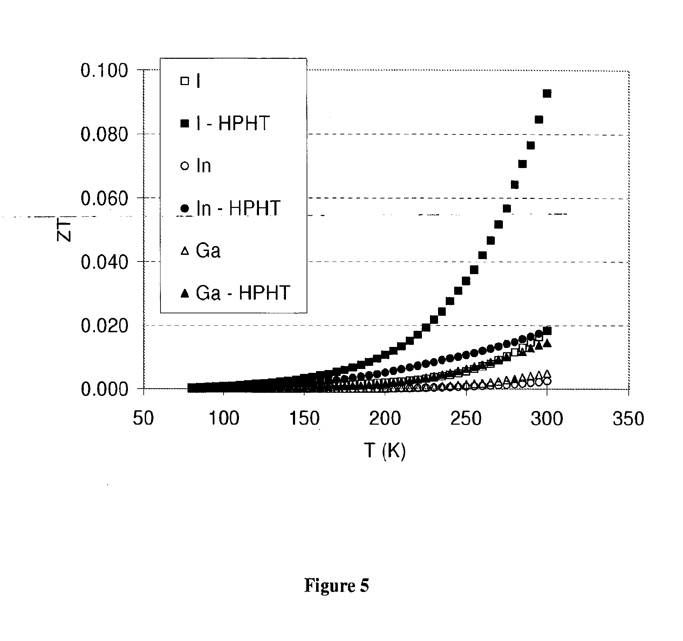

PbTe samples doped with I, In, or Ga, each at a concentration of 1.0 x $10^{19}$ /cm$^3$ were synthesized as describe Example 1. PbI$_2$, InTe, or Ga was used as the dopant source. For I and Ga doping, the reactants were slowly heated over 18 h to reach a temperature of 950 °C. held at this temperature for 3 h, and then rapidly cooled to room temperature. For In doping, the reactants were heated slowly over 18 h to reach 930 °C, held for 2 h, then slowly cooled over 5 h to 850 °C before rapidly cooling to room temperature. Samples were conventionally sintered as described in paragraph [0045] by heating slowly over 8 h to reach 400 °C, holding at that temperature for 12 h, and then rapidly cooling to room temperature. Samples were HPHT sintered at 4.0 GPa and 1045 °C for 10 m, as described in Example 1.
The results for I, In, or Ga doped PbTe are given in Figure 5. It can be seen that HPHT processed doped PbTe exhibits greater ZT values over almost the entire temperature range from 80 to 300 K.

EXAMPLE 4

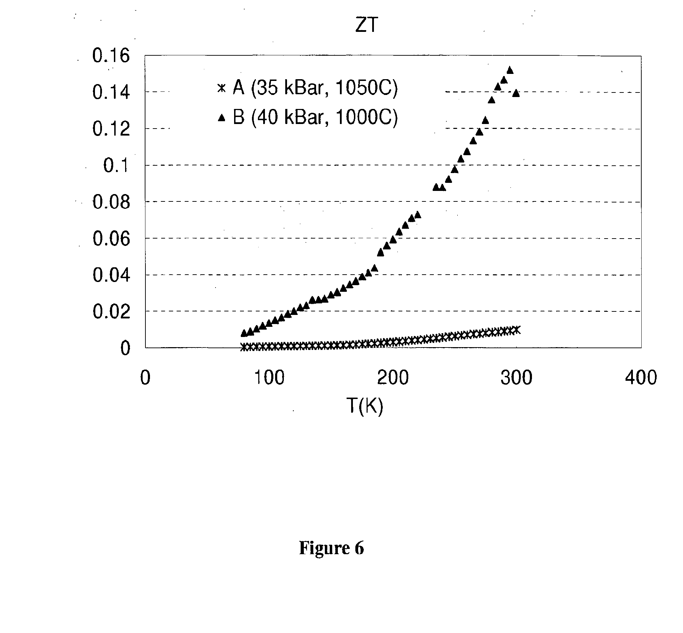

Alloy compositions of PbTe, Pb$_{0.5}$Sn$_{0.5}$Te$_{0.5}$Se$_{0.5}$ doped with Br at a concentration of 1.0 x $10^{19}$ /cm$^3$ were synthesized by mixing the elements in a vacuum sealed silica tube. The reaction tube was gradually heated to 950 °C over 15 h, held at this temperature for 3 h, and then rapidly cooled to room temperature. The composition was sintered under 2 different HPHT conditions; A) 3.5 GPa and 1050 °C and B) 4.0 GPa and 1000 °C. The ZT is graphed in Figure 6. It can be seen that sample B, sintered at 4.0 GPa and 1000 °C has larger ZT over the entire temperature range from 80 to 300 K. This result suggests that the exact HPHT sintering pressure and temperature are necessary to obtain desirable results.

EXAMPLE 5

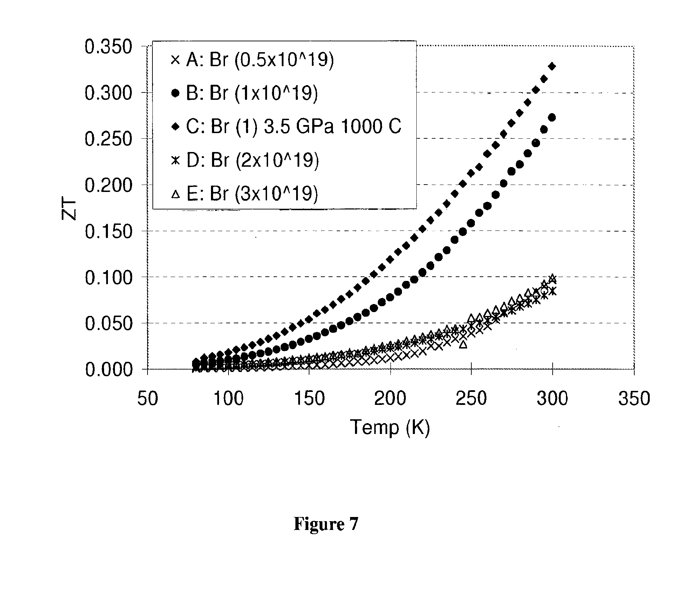

PbTe doped with Br at the levels of 0.5, 1.0, 2.0, and 3.0 x $10^{19}$/cm$^3$ were conventionally synthesized as described in paragraph [0044]. HPHT sintering was done as described in Example 1, at 4.0 GPa and 1045 °C for all samples except sample C which was sintered at 3.5 GPa and 1000 °C. Results plotted in Figure 7 show that Br doping level of 1.0 x $10^{19}$/cm$^3$ gives the optimal ZT over the temperature range of 80 to 300 K. Furthermore, it is clear that sintering at 3.5 GPa and 1000 °C yields higher ZT values over the temperature range of 80 to 300 K.

EXAMPLE 6

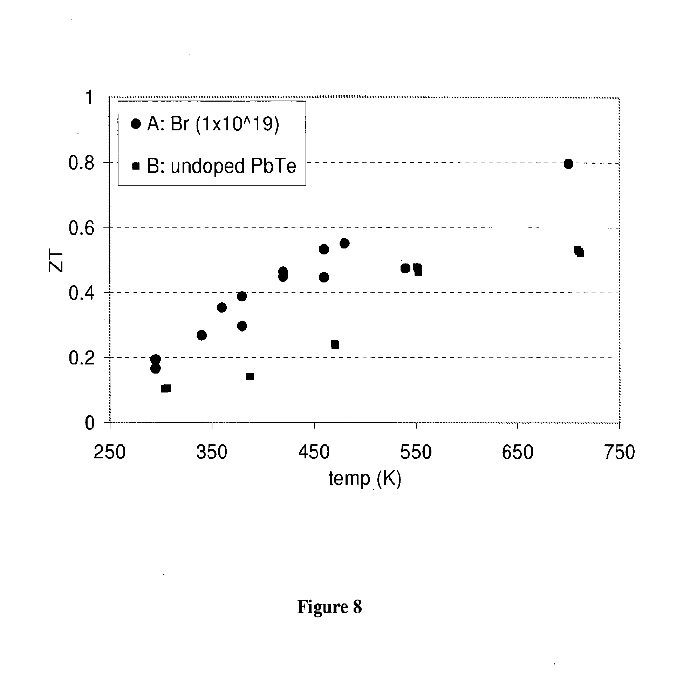

Br doped (1 x $10^{19}$/cm$^3$) PbTe and undoped PbTe was sintered at 4.0 GPa and 1045 °C and their properties were measured in the temperature range from 295 K to 700 K. As shown in Figure 8, the ZT for the Br doped sample is -0.8 whereas it is -0.5 for the undoped sample at 700 K. Clearly, these results compare favorably with the commercially available materials described in Snyder, G.J. and E.S. Toberer, Complex thermoelectric materials. Nature Materials, 2008. 7: p. 105-114. (see Figure 1), which have been optimized by alloying and doping to produce the highest ZT.

**Claims**

1. A method of increasing the ZT of a semiconductor, comprising:

    exposing a semiconductor to an elevated pressure of from about 4 GPa to 8 GPa and an elevated temperature of from about 900° C to about the melting point of the semiconductor at the process pressures for a time sufficient to increase the ZT of the semiconductor; and
    recovering the semiconductor with an increased ZT when measured at the pressure and temperature of use wherein the semiconductor is selected from the group consisting of lead selenide, lead sulfide, lead telluride, tin sulfide, tin telluride, and alloy mixtures thereof.

2. The method of claim 1, wherein the semiconductor comprises lead telluride.

3. The method of any one of claims 1 through 2, wherein the time is from about 30 seconds to about 24 hours.

4. The method of claim 1, wherein the semiconductor further comprises dopants.

5. The method of claim 4, wherein the dopants is selected from Br, Cl, I, Ga, In, Na, K, Ag or other intentional impurities.

**6.** The method of any one of claims 1 through 5, wherein the time is about 5 minutes to about 30 minutes.

**7.** The method of any one of claims 1 through 6, wherein the semiconductor comprises a semiconductor starting powder, wherein the semiconductor starting powder has an average particle size of about 0.05 mm to about 4 mm.

**8.** The method of any one of claims 1 through 7, wherein prior to exposing the semiconductor to elevated pressure and elevated temperature, the semiconductor comprises a powder, a polycrystalline mass, one or more discrete single crystals, or a combination thereof.

**9.** An HPHT-treated high purity semiconductor material selected from the group consisting of lead selenide, lead sulfide, lead telluride, tin sulfide, tin telluride, and alloy mixtures thereof, having a ZT that is higher than a semiconductor material of the same composition that is not HPHT-treated.

**Patentansprüche**

**1.** Verfahren zum Erhöhen der ZT eines Halbleiters, bei dem man:

einen Halbleiter einem erhöhten Druck von etwa 4 GPa bis 8 GPa und einer erhöhten Temperatur von etwa 900° C bis etwa dem Schmelzpunkt des Halbleiters bei den Prozessdrücken aussetzt, für eine Zeitspanne, die zur Erhöhung der ZT des Halbleiters ausreicht, und
den Halbleiter mit einer erhöhter ZT, gemessen bei dem Arbeitsdruck und der Arbeitstemperatur, wiedererhält, wobei der Halbleiter ausgewählt ist aus der Gruppe, die aus Bleiselenid, Bleisulfid, Bleitellurid, Zinnsulfid, Zinntellurid und Legierungsgemischen hieraus besteht.

**2.** Verfahren nach Anspruch 1, wobei der Halbleiter Bleitellurid aufweist.

**3.** Verfahren nach einem der Ansprüche 1 bis 2, wobei die Zeitspanne von etwa 30 Sekunden bis etwa 24 Stunden beträgt.

**4.** Verfahren nach Anspruch 1, wobei der Halbleiter ferner Dotierungen aufweist.

**5.** Verfahren nach Anspruch 4, wobei die Dotierung aus Br, Cl, I, Ga, In, Na, K, Ag oder anderen absichtlichen Verunreinigungen ausgewählt ist.

**6.** Verfahren nach einem der Ansprüche 1 bis 5, wobei die Zeitspanne in etwa 5 Minuten bis etwa 30 Minuten beträgt.

**7.** Verfahren nach einem der Ansprüche 1 bis 6, wobei der Halbleiter ein Halbleiterausgangspulver aufweist, wobei das Halbleiterausgangspulver eine mittlere Korngröße von etwa 0,05 mm bis etwa 4 mm hat.

**8.** Verfahren nach einem der Ansprüche 1 bis 7, wobei der Halbleiter, bevor er einem erhöhten Druck und einer erhöhten Temperatur ausgesetzt wird, ein Pulver, eine polykristalline Masse, ein oder mehrere einzelne Einkristalle oder eine Kombination hiervon aufweist.

**9.** HPHT-behandeltes, hochreines Halbleitermaterial ausgewählt aus der Gruppe bestehend aus Bleiselenid, Bleisulfid, Bleitellurid, Zinnsulfid, Zinntellurid und Legierungsgemischen hieraus, wobei das Material eine ZT hat, welche höher ist als bei einem Halbleitermaterial der gleichen Zusammensetzung, das nicht HPHT-behandelt ist.

**Revendications**

**1.** Un procédé pour augmenter la ZT d'un semi-conducteur, comprenant:

- l'exposition d'un semi-conducteur à une pression élevée d'environ 4 GPa à 8 GPa et à une température élevée comprise entre environ 900°C et environ le point de fusion du semi-conducteur, à la pression à laquelle le procédé est mis en oeuvre, pendant une durée suffisante pour augmenter la ZT du semi-conducteur, et
- la récupération du semi-conducteur avec une ZT augmentée, mesurée à la pression et à la température d'utilisation, le semi-conducteur étant choisi dans le groupe comprenant: séléniure de plomb, sulfure de plomb, tellurure de plomb, sulfure d'étain, tellurure d'étain et des mélanges d'alliages en dérivant.

2. Le procédé selon la revendication 1, dans lequel le semi-conducteur comprend du tellurure de plomb.

3. Le procédé selon l'une des revendications 1 à 2, dans lequel la durée est d'environ 30 secondes à environ 24 heures.

4. Le procédé selon la revendication 1, dans lequel le semi-conducteur comprend en outre des dopants.

5. Le procédé selon la revendication 4, dans lequel les dopants sont choisis dans le groupe comprenant Br, Cl, I, Ga, In, Na, K, Ag ou autres impuretés intentionnelles.

6. Le procédé selon une quelconque des revendications 1 à 5, dans lequel la durée est d'environ 5 minutes à environ 30 minutes.

7. Le procédé selon une quelconque des revendications 1 à 6, dans lequel le semi-conducteur comprend une poudre de départ pour semi-conducteur, dans lequel la poudre de départ semi-conducteur a une taille de particule moyenne d'environ 0,05 mm à environ 4 mm.

8. Le procédé selon l'une quelconque des revendications 1 à 7, dans lequel, avant l'exposition de la semi-conducteur à une pression élevée et à température élevée, le semi-conducteur comprend une poudre, une masse polycristalline, un ou plusieurs monocristaux discrets ou une combinaison de ceux-ci.

9. Un matériau pour semi-conducteur présentant une pureté élevée traité par HPHT, choisi dans le groupe consistant en séléniure de plomb, sulfure de plomb, tellurure de plomb, sulfure d'étain, tellurure d'étain, et des mélanges d'alliages en dérivant, présentant une ZT qui est supérieure à celle d'un matériau semi-conducteur présentant la même composition mais non traité par HPHT.

Snyder, G.J. and E.S. Toberer, *Complex thermoelectric materials.* Nature Materials, 2008. 7: p. 105-114

## Figure 1

**Figure 2**

**Figure 3**

**Figure 4**

**Figure 5**

Figure 6

**Figure 7**

**Figure 8**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008002910 A
- US 2947611 A
- US 2941241 A
- US 2941248 A
- US 3609818 A
- US 3767371 A
- US 4289503 A
- US 4673414 A
- US 4954139 A
- US 3030662 A

**Non-patent literature cited in the description**

- **P. W ZHU et al.** Giant improved thermoelectric properties in PbTe by HPHT at room temperature. *CHEMICAL PHYSICS LETTERS,* 2002, vol. 359, 89-94
- **P.W. ZHU et al.** A new method of synthesis for thermoelectric materials: HPHT. *SOLID STATE COMMUNICATIONS,* 2002, vol. 123, 43-47
- Electrical transport and thermoelectric properties of PbTe doped with Sb2Te3 prepared by high-pressure and high-temperature. **SU et al.** JOURNAL OF ALLOYS AND COMPOUNDS. ELSEVIER SEQUOIA, 26 January 2006, vol. 422, 328-331
- **SHCHENNIKOV V V et al.** Thermopower of lead chalcogenides at high pressures. *PHYSICS OF THE SOLID STATE, NAUKA/INTERPERIODICA, MO,* 01 October 2002, vol. 44 (10), 1845-1849
- Large improvement in thermoelectric properties in pressure-tuned p-type Sb1.5Bi0.5Te3. **POLVANI D A et al.** Database accession no. 7532638 ; & Chemistry of Materials. American Chem. Soc, vol. 13, 2068-2071
- Multifold enhancement of the thermoelectric figure of merit in p-type BaBiTe3 by pressure tuning. **MENG J F et al.** JOURNAL OF APPLIED PHYSICS. AMERICAN INSTITUTE OF PHYSICS, 15 September 2001, vol. 90, 2836-2839
- Effects of high-pressure high-temperature treatment on the thermoelectric properties of PbTe. **MCGUIRE M A et al.** JOURNAL OF ALLOYS AND COMPOUNDS. ELSEVIER SEQUOIA, 28 July 2008, vol. 460, 8-12
- **SNYDER, G.J. ; E.S. TOBERER.** Complex thermoelectric materials. *Nature Materials,* 2008, vol. 7, 105-114